# EUROPEAN PATENT APPLICATION

(11) **EP 4 050 650 A1**
(43) Date of publication of application: **31.08.2022**
(21) Application number: 21159266.2
(22) Date of filing: 25.02.2021
(51) Int. Cl.: H01L 23/498, H01L 23/053, H05K 1/14, H05K 3/28

(54) **POWER SEMICONDUCTOR MODULE ARRANGEMENT**

(71) Applicant: Infineon Technologies AG, 85579 Neubiberg (DE)
(72) Inventor: TSCHIRBS, Roman Lennart, 59494 Soest (DE); BÖNIG, Guido, 59581 Warstein (DE); DE BOCK, Jens, 59557 Lippstadt (DE); GÖRDES, Martin, 59755 Arnsberg (DE)
(74) Representative: Westphal, Mussgnug & Partner, Patentanwälte mbB

(57) **Abstract**

A power semiconductor module arrangement comprises a housing (7), a substrate (10) arranged inside the housing (7) and comprising a dielectric insulation layer (11), and a first metallization layer (111) arranged on a first side of the dielectric insulation layer (11), at least one semiconductor body (20) mounted on a first surface (101) of the first metallization layer (111) which faces away from the dielectric insulation layer (11), a first printed circuit board (81) arranged inside the housing (7) essentially in parallel to and vertically above the substrate (10), and a plurality of first terminal element (44) that is mechanically connected to the first metallization layer (111), wherein each of the plurality of first terminal elements (44) extends from the first metallization layer (111) in a vertical direction (y) perpendicular to the first surface (101) towards the first printed circuit board (81), wherein each of the plurality of first terminal elements (44) comprises a pressfit pin (46), the first printed circuit board (81) comprises a plurality of through holes (810), each of the plurality of pressfit pins (46) is arranged in one of the through holes (810), and the first printed circuit board (81) is held in a desired position with regard to the substrate (10) primarily by means of the plurality of first terminal elements (44) and the connections formed by the plurality pressfit pins (46).

## Description

### TECHNICAL FIELD

The instant disclosure relates to a power semiconductor module arrangement, in particular to a power semiconductor module arrangement comprising at least one printed circuit board.

### BACKGROUND

Power semiconductor module arrangements often include a substrate within a housing. The substrate usually comprises a substrate layer (e.g., a ceramic layer), a first metallization layer deposited on a first side of the substrate layer and, optionally, a second metallization layer deposited on a second side of the substrate layer. A semiconductor arrangement including one or more controllable semiconductor elements (e.g., two IGBTs in a half-bridge configuration) may be arranged on the substrate. One or more contact elements, which allow for contacting such a semiconductor arrangement from outside the housing, are usually provided. Power semiconductor modules are known, where the contact elements are arranged on the substrate and protrude in a direction that is essentially perpendicular to the main surface of the substrate through a cover of the housing. The section of the contact elements which protrudes out of the housing may be mechanically and electrically coupled to a printed circuit board. Such arrangements are usually large and bulky.

There is a need for a power semiconductor module arrangement that is compact and small in size.

### SUMMARY

A power semiconductor module arrangement includes a housing, a substrate arranged inside the housing and comprising a dielectric insulation layer, and a first metallization layer arranged on a first side of the dielectric insulation layer, at least one semiconductor body mounted on a first surface of the first metallization layer which faces away from the dielectric insulation layer, a first printed circuit board arranged inside the housing essentially in parallel to and vertically above the substrate, and a plurality of first terminal element that is mechanically connected to the first metallization layer, wherein each of the plurality of first terminal elements extends from the first metallization layer in a vertical direction perpendicular to the first surface towards the first printed circuit board, wherein each of the plurality of first terminal elements comprises a pressfit pin, the first printed circuit board comprises a plurality of through holes, each of the plurality of pressfit pins is arranged in one of the through holes, and the first printed circuit board is held in a desired position with regard to the substrate primarily by means of the plurality of first terminal elements and the connections formed by the plurality pressfit pins.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3, is a cross-sectional view of another power semiconductor module arrangement.
Figure 4, including Figures 4A and 4B, schematically illustrates a pressfit connection.
Figure 5 is a cross-sectional view of an exemplary power semiconductor module arrangement.
Figure 6, including Figures 6A and 6B, schematically illustrates exemplary contact elements.
Figure 7 is a cross-sectional view of a contact element.
Figure 8 is a cross-sectional view of a power semiconductor module arrangement according to one example.
Figure 9 is a cross-sectional view of a power semiconductor module arrangement according to another example.
Figure 10 is a cross-sectional view of a contact element according to one example.
Figure 11 is a cross-sectional view of a power semiconductor module arrangement according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

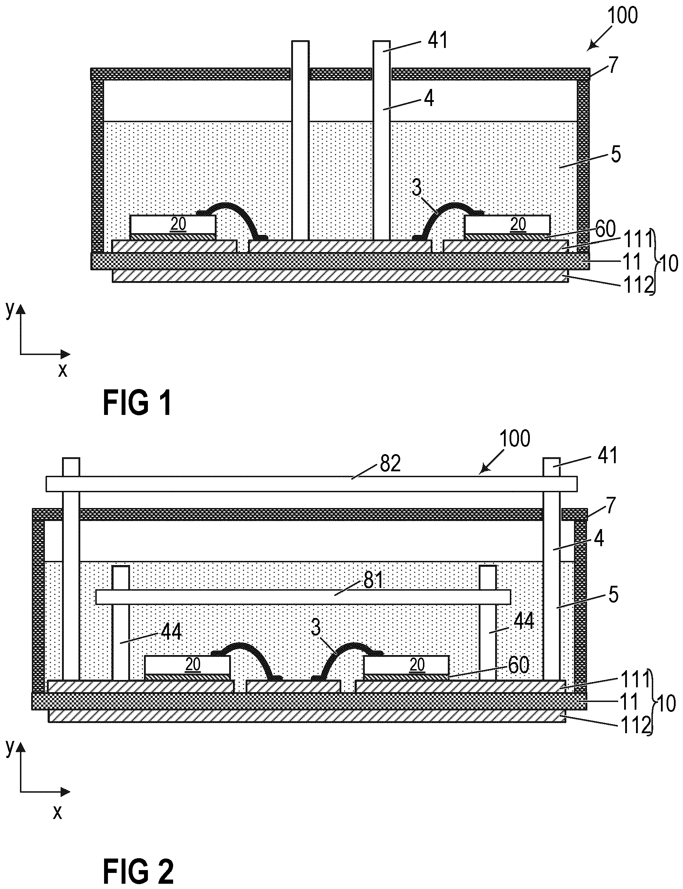

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and a cover. This, however, is only an example. It is also possible that the housing 7 further comprises a base surface and the substrate 10 is arranged on the base surface inside the housing 7. According to another example (not specifically illustrated), the substrate 10 may be mounted on a base plate. The base plate may form a bottom of the housing 7. In some power semiconductor module arrangements 100, more than one substrate 10 is arranged within the same housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor dies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer to or adjacent to the sidewalls of the housing 7. It is also possible that terminal elements 4 protrude vertically or horizontally through the sidewalls of the housing 7. It is even possible that terminal elements 4 protrude through a ground surface of the housing 7. The first end of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end of a terminal element 4 may also be electrically coupled to the substrate via one or more electrical connections 3, for example. For example, the second ends 41 of the terminal elements 4 may be connected to a printed circuit board (not illustrated in Figure 1).

The power semiconductor module arrangement 100 generally further includes a encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

Now referring to Figure 2, a power semiconductor module arrangement 100 according to one example is schematically illustrated. The power semiconductor module arrangement 100 of Figure 2 essentially corresponds to the power semiconductor module arrangement 100 that has been explained with respect to Figure 1 above. However, the power semiconductor module arrangement 100 illustrated in Figure 2 comprises first terminal elements 44 and second terminal elements 4. The second terminal elements 4 essentially correspond to the terminal elements 4 that have been described with respect to Figure 1 above. That is, the second ends 41 of the second terminal elements 4 protrude out of the housing 7. The first terminal elements 44 on the other hand are arranged entirely inside the housing 7 and do not extend to the outside of the housing 7. A first printed circuit board 81 is coupled to the first terminal elements 44. The first printed circuit board 81, therefore, is also arranged inside the housing 7. The second ends 41 of the second terminal elements 4 are connected to a second printed circuit board 82 that is arranged outside the housing 7. By arranging a printed circuit board inside the housing 7, the power semiconductor module arrangement 100 can be implemented in a compact and space saving way. This is, because a certain number of a plurality of components that is usually arranged on an external printed circuit board can be arranged on the first printed circuit board 81 instead of on the second printed circuit board 82. The size of the second printed circuit board 82, therefore, can be reduced as compared to arrangements only comprising the second printed circuit board 82 outside the housing 7 but not the first printed circuit board 81 inside the housing 7.

The first terminal elements 44 are configured to electrically contact the first printed circuit board 81. The first terminal elements 44 are further configured to hold the first printed circuit board 81 in its position with regard to the substrate 10. In particular, the first printed circuit board 81 is arranged essentially parallel to and vertically above the substrate 10. Certain tolerances may occur during assembly, therefore, deviations of ±15° from an exact parallel arrangement can occur. The vertical direction y is a direction perpendicular to a top surface of the substrate 10, wherein the top surface of the substrate 10 is a surface on which the semiconductor bodies 20 are mounted. The first printed circuit board 81 is vertically spaced apart from the substrate 10, that is, the first printed circuit board 81 and the substrate 10 are not in direct contact with each other. A contact between the first printed circuit board 81 and the substrate 10 is solely provided by the first terminal elements 44.

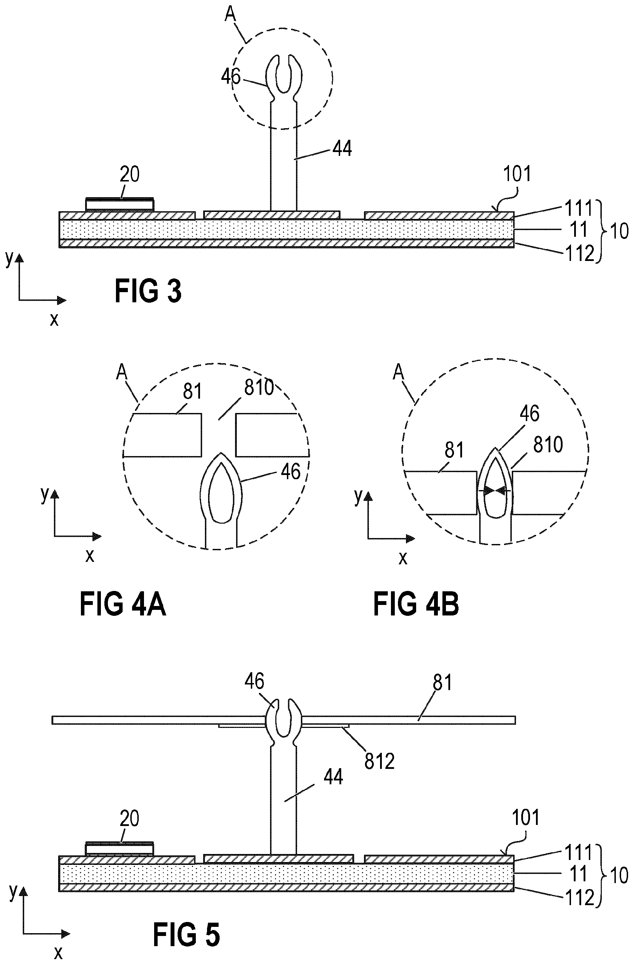

In order to be able to securely hold the first printed circuit board 81 in a defined position with regard to the substrate 10 and to (electrically) contact the first printed circuit board 81, the first terminal elements 44 comprise pressfit pins. A first terminal element 44 comprising a pressfit pin 46 is schematically illustrated in Figure 3. Figure 3, in particular, illustrates a semiconductor body 20 and a first terminal element 44 arranged on a substrate 10. Any other components are omitted in Figure 3 for the sake of clarity. The first terminal element 44 includes a pressfit pin 46 at its second end, which faces away from the substrate 10. The second end of such a first terminal element 44 is exemplarily illustrated in Figure 4, where Figure 4A schematically illustrates a pressfit pin 46 and the corresponding counterpart (e.g., a through hole 810 in the first printed circuit board 81) in a non-assembled state, and Figure 4B schematically illustrates the press-fit pin 46 and the corresponding counterpart in an assembled state. The through hole 810 may form an appropriate counterpart for the pressfit pin 46 of the first terminal element 44. While not connected to the counterpart, a pressfit pin 46 has a larger width than its counterpart. The width of the pressfit pin 46 is a width in a horizontal direction x, z parallel to a top surface 101 of the semiconductor substrate 10. During the press-in process, the pressfit pin 46 is pushed into the counterpart. This results in a plastic deformation of the pressfit pin 46 (illustrated by means of the arrows in Figure 4B). When inserted into the counterpart, the width of the pressfit pin 46 is reduced. Only small insertion forces are generally necessary with high holding forces at the same time. The pressfit pin 46 and the counterpart, after inserting the pressfit pin 46, are firmly attached to each other. The reduced width of the pressfit pin 46 results in a force which counteracts the compression of the pressfit pin 46. The first terminal element 44, therefore, may not be easily detached from the through hole 810.

The use of a pressfit connection makes it easy to assemble the power semiconductor module arrangement 100. That is, the first printed circuit board 81 can be easily arranged above the substrate 10 and the pressfit pins 46 of the first terminal elements 44 can be easily inserted into respective through holes 810 in the first printed circuit board 81. When the first terminal elements 44 have been inserted into the respective through holes 810 in the first printed circuit board 81, the first printed circuit board 81 is securely held in its desired position above the substrate 10. This is schematically illustrated in Figure 5. In Figure 5 only one first terminal element 44 is illustrated for illustration purposes. Generally, however, a plurality of first terminal elements 44 is needed to securely hold the first printed circuit board 81 in its position and to prevent the first printed circuit board 81 from tilting unintendedly. Each of the plurality of first terminal elements 44 can be electrically coupled to the first printed circuit board 81. For example, the pressfit pin 46 of a first terminal element 44 can be in contact with a conductor track 812 of the first printed circuit board 81, as is exemplarily illustrated in Figure 5. A plurality of conductor tracks 812 is generally arranged on a printed circuit board. Conductor tracks 812 can be arranged on a lower surface of the first printed circuit board 81 as illustrated in Figure 5, or on a top surface, the lower surface being a surface facing the substrate 10 and the top surface being a surface facing away from the substrate 10.

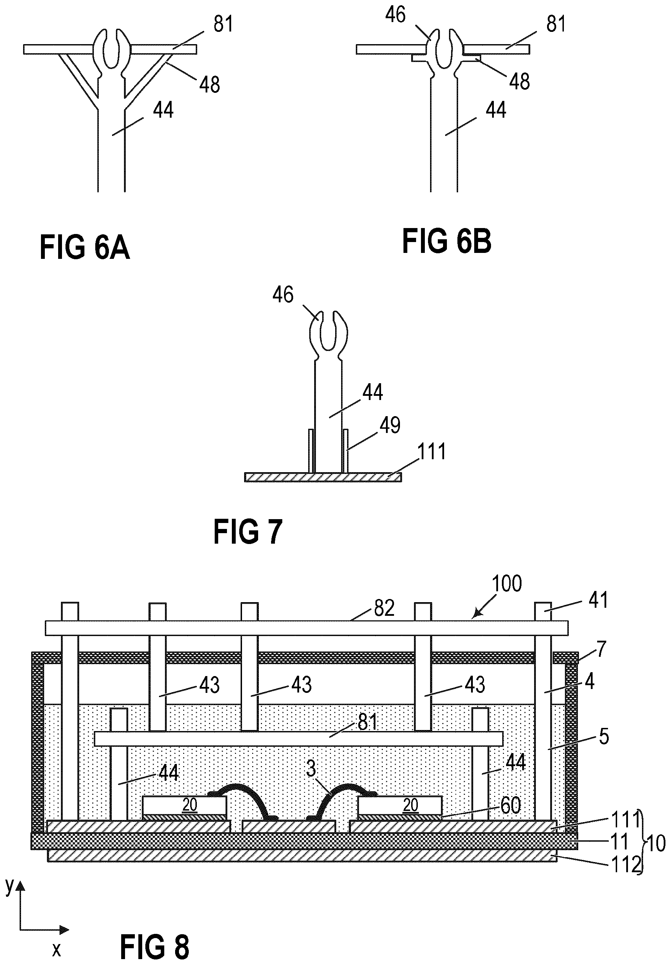

The counterforces of the plurality of pressfit pins 46, which counteract the deformation of the pressfit pins 46 are generally sufficient in order to prevent the first printed circuit board 81 from being pushed further towards the substrate 10. However, according to one example, one or more of the first terminal elements 44 can further comprise a holding device 48. The holding device 48 is configured to form a barrier or end stop for the first printed circuit board 81 and to prevent the pressfit pin 46 from entirely being pushed through the through hole 810. In this way, the first printed circuit board 81 can be held at a defined distance above the substrate 10. The holding device 48 can comprise a protrusion, collar or edge, as is schematically illustrated in Figure 6B, for example. The holding device 48, however, can have any other suitable form. Another example of a holding device 48 is schematically illustrated in Figure 6A. The holding device 48 in this example comprises bars which extend diagonally from the first terminal element 44 towards the first printed circuit board 81. In this way, the bars and the pressfit pin 46 can have the form of a trident or rake, for example. In the example illustrated in Figure 6A, two bars are illustrated which are arranged on two opposite sides of the first terminal element 44. The holding element 48, however, can comprise more than two bars extending from the first terminal element 44. The two or more bars can be arranged in regular intervals around a perimeter of the first terminal element 44.

The first terminal elements 44 and the second terminal elements 4 can be mounted to the substrate 10 by means of an electrically conductive connection layer, for example. Such an electrically conductive connection layer may be a solder layer, a layer of an electrically conductive adhesive, a welding seam, or a layer of a sintered metal powder, e.g., a sintered silver (Ag) powder, for example. According to another example, the first terminal elements 44 can be inserted into sleeves or rivets 49 which are arranged on the substrate 10. The rivets 49 can be mounted to the substrate 10 by means of an electrically conductive connection layer, for example. Such an electrically conductive connection layer may be a solder layer, a layer of an electrically conductive adhesive, a welding seam, or a layer of a sintered metal powder, e.g., a sintered silver (Ag) powder, for example. The first terminal elements 44 can have the form of pins at their first ends which point towards the substrate 10 and therefore can be easily inserted into the rivets 49. This is schematically illustrated in Figure 7. The same applies for the second terminal elements 4 (not specifically illustrated in connection with rivets).

In the example illustrated in Figure 2, the power semiconductor module arrangement comprises first terminal elements 44 and second terminal elements 4. As is exemplarily illustrated in Figure 8, the arrangement can further comprise third terminal elements 43. The third terminal elements 43 are arranged on the first printed circuit board 81 and extend from the first printed circuit board 81 through the housing 7 to the outside of the housing 7. Outside the housing 7, the third terminal elements 43 are mechanically end electrically coupled to the second printed circuit board 82. That is, the third terminal elements 43 form a connection between the first printed circuit board 81 and the second printed circuit board 82. The third terminal elements 43, however, are not coupled to the substrate 10. The third terminal elements 43 can be implemented in the same way as the first terminal elements 44, or as the second terminal elements 4, for example.

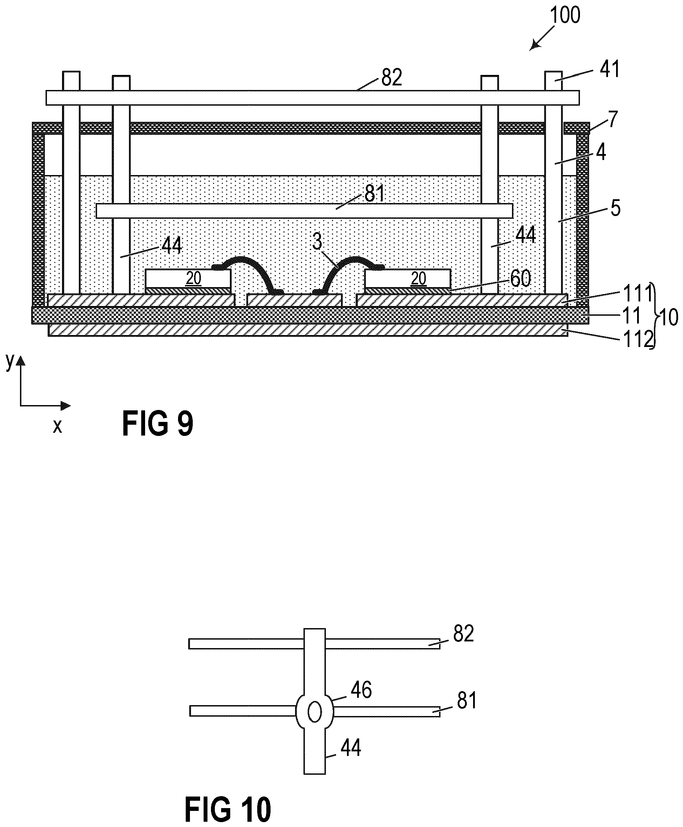

According to an even further example, the first terminal elements 44 can form a connection between the substrate 10 and the first printed circuit board 81, as has been described above, and can extend further to the outside of the housing 7, there forming a further connection to the second printed circuit board 82. This is schematically illustrated in Figure 9. That is, in the example illustrated in Figure 9, the first terminal elements 44 are mechanically coupled to each of the substrate 10, the first printed circuit board 81 and the second printed circuit board 82. In this example, the first printed circuit board 81 can still be held in position by means of pressfit connections 46. This is schematically illustrated in Figure 10. In the examples described above by means of Figures 2 to 8, the pressfit connection 46 is formed at a top end of the first terminal element 44, the top end being the end of the first terminal element 81 that is arranged the furthest away from the substrate 10. Contrary to this, in the example of Figures 9 and 10, the pressfit connection 46 is formed in a center section of the first terminal element 44. The center section is arranged between the top end and the lower end of the first terminal element 44, the lower end being the end of the first terminal element 44 that is coupled to the substrate 10. The top end and the lower end of the first terminal element 44 can be implemented as simple pins, for example. The lower end can be mechanically coupled to the substrate 10 in the same way as has been described with respect to Figures 1 to 8 above. The top end can extend through an opening or through hole in the second printed circuit board 82 and can be mechanically coupled to the second printed circuit board 82 by means of a solder connection, for example. The first printed circuit board 81 can be mechanically coupled to the first terminal element 44 by means of the pressfit connection 46 in the same way as has been described above, the only difference being that the pressfit connection 46 does not form a top end of the first terminal element 44.

The first terminal element 44 as illustrated in Figures 9 and 10 can comprise a holding device 48, as has been described with respect to Figure 6 above, for example, for providing further stability of the first printed circuit board 81. The first printed circuit board 81 in this example as in the examples described above is held in the desired position solely or at least primarily by means of the pressfit connections 46. Additional end stops or supporting surfaces formed by the housing 7, for example, are not needed to hold the first printed circuit board 81 in its position. That is, the first printed circuit board 81 is not necessarily in contact with the housing 7. Additional end stops or supporting surfaces formed by the housing 7 can be provided for supplementary support, however, the main load is carried by the pressfit connections 46. According to one example, the first printed circuit board 81 is held in its desired position by at least 90% by means of the pressfit connections 46.

The housing 7 has a first cross-sectional area in a horizontal plane. This cross-sectional area can be larger than a cross-sectional area of the first printed circuit board 81. That is, there is a gap between the first printed circuit board 81 and the sidewalls of the housing 7, as is illustrated throughout the Figures. The first printed circuit board 81 can be arranged in the housing 7 and fixed in position by means of the pressfit connections 46 of the plurality of first terminal elements 44. Due to the gap provided between the first printed circuit board 81 and the sidewalls of the housing 7 it is possible to subsequently form the encapsulant 5 by pouring a suitable material into the housing 7. In this way, the encapsulant 5 can be formed between the first printed circuit board 81 and the substrate 10, even if the first printed circuit board 81 is already arranged inside the housing 7.

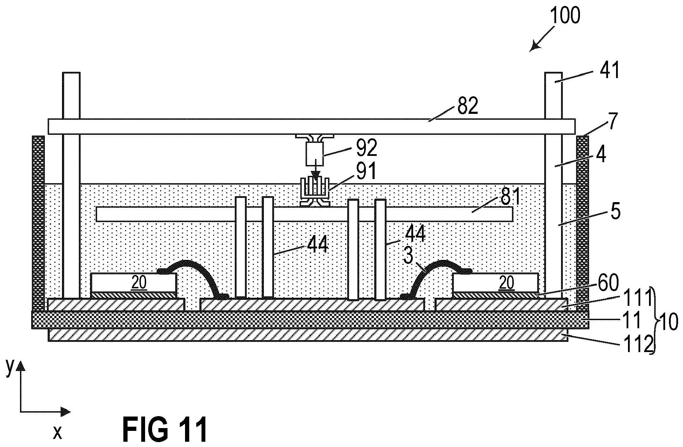

The pressfit connections 46 formed between the first terminal elements 44 and the first printed circuit board 81 are very stable mechanical connections. That is, the first printed circuit board 81 is held in the desired position even if a comparably great force in the direction of the substrate 10 is exerted on the first printed circuit board 81. This may be the case, for example, if a plug connection is formed between the first printed circuit board 81 and the second printed circuit board 82. This is schematically illustrated in Figure 11. A first connector part 91 is arranged on a top surface of the first printed circuit board 81, and a second connector part 92 is arranged on a lower surface of the second printed circuit board 82, the lower surface being a surface facing towards the substrate 10. That is, the first connector part 91 and the second connector part 92 face each other. When arranging the second printed circuit board 82 on the power semiconductor module arrangement 100, the second connector part 92 is inserted into the first connector part 91 and a plug connection is formed. In order to form the plug connection, however, a certain force is exerted on the first printed circuit board 81 in the direction of the substrate 10. That is, the first printed circuit board 81 may be pushed towards the substrate 10. In order to prevent the first printed circuit board 81 from being pushed towards the substrate 10, thereby leaving the desired position, a plurality of first terminal elements 44 can be arranged close to the first connector part 91, for example. That is, two or more first terminal elements 44 can be arranged within a perimeter, e.g. 5mm (millimeter) or less, around the first connector part 91. In this way, the holding force which keeps the first printed circuit board 81 in the desired position can be increased specifically in that area that is subject to a force resulting from the insertion of the second connector part 92 in the first connector part 91.

Generally, the arrangement of the first terminal elements 44 on the substrate 10 is not restricted to specific positions. The first terminal elements 44 can be arranged in any suitable position of the substrate 10. That is, they can either be arranged close to the edges of the substrate 10 or anywhere centrally on the substrate 10. The number of first terminal elements 44 can depend on the number of electrical connections required between the substrate 10 and the first printed circuit board 81 and possibly the second printed circuit board 82. The number of first terminal elements 44, however, can also be chosen in order to provide sufficient mechanical stability of the first printed circuit board 81. In this context it is possible that one or more of the first terminal elements 44 are solely used to mechanically hold the first printed circuit board 81 in its position without providing an electrical connection between the substrate 10, the first printed circuit board 81 and, optionally, the second printed circuit board 82.

In the examples described above, there is only one printed circuit board, namely the first printed circuit board 81, arranged inside the housing 7. However, it is also possible to arrange more than just one printed circuit board inside the housing 7. Two or more printed circuit boards can be arranged inside the housing either next to each other in a horizontal direction, or parallel to each other in different horizontal planes inside the housing 7. Printed circuit boards arranged in different horizontal planes can overlap completely or only partly.

The terminal elements described herein with regard to the different figures can be combined with each other in a single arrangement. That is, a power semiconductor module arrangement 100 can comprise first terminal elements 44 as described with respect to Figures 5 to 8 and/or first terminal elements 44 as described with respect to Figures 9 and 10, second terminal elements 4, and, optionally, third terminal elements 43 as described with respect to Figure 8.

## Claims

1. A power semiconductor module arrangement (100) comprising:
a housing (7);
a substrate (10) arranged inside the housing (7) and comprising a dielectric insulation layer (11), and a first metallization layer (111) arranged on a first side of the dielectric insulation layer (11);
at least one semiconductor body (20) mounted on a first surface (101) of the first metallization layer (111) which faces away from the dielectric insulation layer (11);
a first printed circuit board (81) arranged inside the housing (7) essentially in parallel to and vertically above the substrate (10); and
a plurality of first terminal element (44) that is mechanically connected to the first metallization layer (111), wherein each of the plurality of first terminal elements (44) extends from the first metallization layer (111) in a vertical direction (y) perpendicular to the first surface (101) towards the first printed circuit board (81), wherein
each of the plurality of first terminal elements (44) comprises a pressfit pin (46),
the first printed circuit board (81) comprises a plurality of through holes (810),
each of the plurality of pressfit pins (46) is arranged in one of the through holes (810), and
the first printed circuit board (81) is held in a desired position with regard to the substrate (10) primarily by means of the plurality of first terminal elements (44) and the connections formed by the plurality pressfit pins (46).

2. The power semiconductor module arrangement of claim 1, wherein at least one of the plurality of pressfit pins (46) is arranged at a top end of the respective first terminal element (44), wherein the top end is an end of the first terminal elements (44) facing away from the substrate (10).

3. The power semiconductor module arrangement of claim 1 or 2, wherein at least one of the plurality of pressfit pins (46) is arranged in a center section of the respective first terminal element (44), wherein the center section is arranged between the top end and the lower end of the respective first terminal element (44), the lower end being the end of the first terminal element (44) that is coupled to the substrate (10).

4. The power semiconductor module arrangement of claim 3, wherein, if a pressfit pin (46) is arranged in the center section of the respective first terminal element (44), the top end of the respective first terminal element (44) is mechanically coupled to a second printed circuit board (82).

5. The power semiconductor module arrangement of any of claims 1 to 4, wherein at least one of the at least one first terminal element (44) further comprises a holding device (48) that is configured to form a barrier or end stop for the first printed circuit board (81) and to prevent the pressfit pin (46) from entirely being pushed through the respective through hole (810).

6. The power semiconductor module arrangement of claim 5, wherein each of the at least one holding device (48) comprises
either a protrusion, collar or edge, or
two or more bars which extend diagonally from the first terminal element (44) towards the first printed circuit board (81).

7. The power semiconductor module arrangement of any of claims 1 to 6, further comprising at least one second terminal element (4) mechanically coupled to the substrate (10) with a lower end, and to a second printed circuit board (82) with a first end (41), wherein the first ends (41) of the at least one second terminal element (4) extend to the outside of the housing (7), and wherein the second printed circuit board (82) is arranged outside the housing (7).

8. The power semiconductor module arrangement of claim 7, wherein the at least one second terminal element (4) does not contact the first printed circuit board (81).

9. The power semiconductor module arrangement of any of the preceding claims, further comprising
a connector part (91) arranged on a top surface of the first printed circuit board (81), the top surface being a surface facing away from the substrate (10), and the connector part (91) being configured for electrical connection to circuitry outside the housing (7).

10. The power semiconductor module arrangement of claim 9, wherein at least two first terminal elements (44) are arranged within a perimeter of 5mm or less from the first connector part (91).

11. The power semiconductor module arrangement of any of the preceding claims, further comprising a connection layer between each of the plurality of first terminal elements (44) and the first metallization layer (111).

12. The power semiconductor module arrangement of claim 11, wherein the connection layer comprises at least one of
a solder layer;
an electrically conductive adhesive;
a layer of a sintered metal powder; and
a welding seam.

13. The power semiconductor module arrangement of any of claims 1 to 10, further comprising a plurality of rivets (49) arranged on the substrate (10), wherein a lower end of each of the plurality of first terminal elements (44) is inserted into one of the rivets (49).

14. The power semiconductor module arrangement of any of the preceding claims, further comprising
a second printed circuit board (82) arranged outside the housing (7); and
at least one third terminal element (43) arranged on the first printed circuit board (81) and extending from the first printed circuit board (81) through the housing (7) to the outside of the housing (7), wherein, outside the housing (7), the third terminal elements (43) are mechanically end electrically coupled to the second printed circuit board (82).

## Amended claims

### Amended claims in accordance with Rule 137(2) EPC.

1. A power semiconductor module arrangement (100) comprising:
a housing (7);
a substrate (10) arranged inside the housing (7) and comprising a dielectric insulation layer (11), and a first metallization layer (111) arranged on a first side of the dielectric insulation layer (11);
at least one semiconductor body (20) mounted on a first surface (101) of the first metallization layer (111) which faces away from the dielectric insulation layer (11);
a first printed circuit board (81) arranged inside the housing (7) essentially in parallel to and vertically above the substrate (10); and
a plurality of first terminal element (44) that is mechanically connected to the first metallization layer (111), wherein each of the plurality of first terminal elements (44) extends from the first metallization layer (111) in a vertical direction (y) perpendicular to the first surface (101) towards the first printed circuit board (81), wherein
each of the plurality of first terminal elements (44) comprises a pressfit pin (46),
the first printed circuit board (81) comprises a plurality of through holes (810),
each of the plurality of pressfit pins (46) is arranged in one of the through holes (810),
the first printed circuit board (81) is held in a desired position with regard to the substrate (10) by means of the plurality of first terminal elements (44) and the connections formed by the plurality pressfit pins (46) such that additional end stops or supporting surfaces formed by the housing are not needed to hold the first printed circuit board (81) in its position, and
at least one of the plurality of pressfit pins (46) is arranged in a center section of the respective first terminal element (44), wherein the center section is arranged between the top end and the lower end of the respective first terminal element (44), the lower end being the end of the first terminal element (44) that is coupled to the substrate (10).

2. The power semiconductor module arrangement of claim 1, wherein at least one of the plurality of pressfit pins (46) is arranged at a top end of the respective first terminal element (44), wherein the top end is an end of the first terminal elements (44) facing away from the substrate (10).

3. The power semiconductor module arrangement of claim 1 or 2, wherein, if a pressfit pin (46) is arranged in the center section of the respective first terminal element (44), the top end of the respective first terminal element (44) is mechanically coupled to a second printed circuit board (82).

4. The power semiconductor module arrangement of any of claims 1 to 3, wherein at least one of the at least one first terminal element (44) further comprises a holding device (48) that is configured to form a barrier or end stop for the first printed circuit board (81) and to prevent the pressfit pin (46) from entirely being pushed through the respective through hole (810).

5. The power semiconductor module arrangement of claim 4, wherein each of the at least one holding device (48) comprises
either a protrusion, collar or edge, or
two or more bars which extend diagonally from the first terminal element (44) towards the first printed circuit board (81).

6. The power semiconductor module arrangement of any of claims 1 to 5, further comprising at least one second terminal element (4) mechanically coupled to the substrate (10) with a lower end, and to a second printed circuit board (82) with a first end (41), wherein the first ends (41) of the at least one second terminal element (4) extend to the outside of the housing (7), and wherein the second printed circuit board (82) is arranged outside the housing (7).

7. The power semiconductor module arrangement of claim 6, wherein the at least one second terminal element (4) does not contact the first printed circuit board (81).

8. The power semiconductor module arrangement of any of the preceding claims, further comprising
a connector part (91) arranged on a top surface of the first printed circuit board (81), the top surface being a surface facing away from the substrate (10), and the connector part (91) being configured for electrical connection to circuitry outside the housing (7).

9. The power semiconductor module arrangement of claim 8, wherein at least two first terminal elements (44) are arranged within a perimeter of 5mm or less from the first connector part (91).

10. The power semiconductor module arrangement of any of the preceding claims, further comprising a connection layer between each of the plurality of first terminal elements (44) and the first metallization layer (111).

11. The power semiconductor module arrangement of claim 10, wherein the connection layer comprises at least one of
a solder layer;
an electrically conductive adhesive;
a layer of a sintered metal powder; and
a welding seam.

12. The power semiconductor module arrangement of any of claims 1 to 9, further comprising a plurality of rivets (49) arranged on the substrate (10), wherein a lower end of each of the plurality of first terminal elements (44) is inserted into one of the rivets (49).

13. The power semiconductor module arrangement of any of the preceding claims, further comprising
a second printed circuit board (82) arranged outside the housing (7); and
at least one third terminal element (43) arranged on the first printed circuit board (81) and extending from the first printed circuit board (81) through the housing (7) to the outside of the housing (7), wherein, outside the housing (7), the third terminal elements (43) are mechanically end electrically coupled to the second printed circuit board (82).
